(19) Europäisches Patentamt
European Patent Office
Office européen des brevets

(11) **EP 4 510 421 A1**

(12) **EUROPEAN PATENT APPLICATION**
published in accordance with Art. 153(4) EPC

(43) Date of publication:
**19.02.2025 Bulletin 2025/08**

(21) Application number: **23807236.7**

(22) Date of filing: **17.02.2023**

(51) International Patent Classification (IPC):
$H02J\ 7/02^{(2016.01)}$     $H01M\ 10/44^{(2006.01)}$
$H01M\ 10/48^{(2006.01)}$     $H02J\ 3/32^{(2006.01)}$
$H02J\ 3/38^{(2006.01)}$     $H02J\ 7/00^{(2006.01)}$
$H02J\ 7/34^{(2006.01)}$     $H02J\ 13/00^{(2006.01)}$

(52) Cooperative Patent Classification (CPC):
H01M 10/44; H01M 10/48; H02J 3/32; H02J 3/38;
H02J 7/00; H02J 7/02; H02J 7/34; H02J 13/00

(86) International application number:
**PCT/JP2023/005665**

(87) International publication number:
**WO 2023/223618 (23.11.2023 Gazette 2023/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.05.2022 JP 2022082868**

(71) Applicant: **Mitsubishi Heavy Industries, Ltd.
Tokyo 100-8332 (JP)**

(72) Inventors:
• **KOBAYASHI, Yu
Tokyo 100-8332 (JP)**
• **HASHIMOTO, Masayuki
Tokyo 100-8332 (JP)**

(74) Representative: **Studio Torta S.p.A.
Via Viotti, 9
10121 Torino (IT)**

(54) **CHARGE/DISCHARGE CONTROL DEVICE, CHARGE/DISCHARGE CONTROL METHOD, AND PROGRAM**

(57)    This charge/discharge control device is used in a power storage system having a plurality of storage batteries, the charge/discharge control device comprising: a storage battery information acquisition unit that acquires storage battery information including a degree of health of each of the plurality of storage batteries; an overall command value acquisition unit that acquires a first charge/discharge electric power command value indicating a charge/discharge electric power requested for the power storage system overall; and a command value calculation unit that, on the basis of the degree of health, calculates a second charge/discharge electric power command value indicating a charge/discharge electric power allocated to each of the storage batteries from within the first charge/discharge electric power command value.

FIG. 2

**Description**

Technical Field

The present disclosure relates to a charge/discharge control device, a charge/discharge control method, and a program.

Priority is claimed to Japanese Patent Application No. 2022-082868, filed May 20, 2022, the contents of which are incorporated herein by reference.

Background Art

In a power storage system using a plurality of storage batteries, it is considered to calculate charge/discharge electric power (charge/discharge command values) for each storage battery based on the state of charge (SOC) of each storage battery. For example, PTL 1 discloses a technique for increasing a charge/discharge command value for a storage battery having a high SOC and decreasing a charge/discharge command value for a storage battery having a low SOC to balance the SOC of each storage battery.

Citation List

Patent Literature

[PTL 1] Japanese Unexamined Patent Application Publication No. 2021-093804

Summary of Invention

Technical Problem

However, in the technique of the related art, the state of health (degree of deterioration) of the storage battery is not considered, so that there is a possibility that the state of health varies between the storage batteries.

An object of the present disclosure is to provide a charge/discharge control device, a charge/discharge control method, and a program capable of reducing variations in the state of health between a plurality of storage batteries included in a power storage system.

Solution to Problem

According to an aspect of the present disclosure, a charge/discharge control device is a charge/discharge control device of a power storage system including a plurality of storage batteries, the charge/discharge control device including: a storage battery information acquisition unit that acquires storage battery information including a state of health of each of the plurality of storage batteries; an overall command value acquisition unit that acquires a first charge/discharge electric power command value indicating charge/discharge electric power required for an entire power storage system; and a command value calculation unit that calculates a second charge/discharge electric power command value, which indicates charge/discharge electric power to be assigned to each of the storage batteries, out of the first charge/discharge electric power command value, based on the state of health.

According to an aspect of the present disclosure, a charge/discharge control method is a charge/discharge control method of a power storage system including a plurality of storage batteries, the charge/discharge control method including: a step of acquiring storage battery information including a state of health of each of the plurality of storage batteries; a step of acquiring a first charge/discharge electric power command value indicating charge/discharge electric power required for an entire power storage system; and a step of calculating a second charge/discharge electric power command value, which indicates charge/discharge electric power to be assigned to each of the storage batteries, out of the first charge/discharge electric power command value, based on the state of health.

According to an aspect of the present disclosure, a program causes a charge/discharge control device of a power storage system including a plurality of storage batteries to execute a step of acquiring storage battery information including a state of health of each of the plurality of storage batteries, a step of acquiring a first charge/discharge electric power command value indicating charge/discharge electric power required for an entire power storage system, and a step of calculating a second charge/discharge electric power command value, which indicates charge/discharge electric power to be assigned to each of the storage batteries, out of the first charge/discharge electric power command value, based on the state of health.

Advantageous Effects of Invention

According to the above aspect, it is possible to reduce the variations in the state of health between the plurality of storage batteries included in the power storage system.

Brief Description of Drawings

Fig. 1 is a diagram showing an overall configuration of a power storage control system according to an embodiment.
Fig. 2 is a block diagram showing a functional configuration of the charge/discharge control device according to the embodiment.
Fig. 3 is a first flowchart showing an example of processing of the charge/discharge control device according to the embodiment.
Fig. 4 is a first diagram for describing functions of a charge/discharge control device according to the embodiment.
Fig. 5 is a second flowchart showing an example of the processing of the charge/discharge control device according to the embodiment.
Fig. 6 is a third flowchart showing an example of the processing of the charge/discharge control device according to the embodiment.
Figs. 7A and 7B are second diagrams for describing the functions of the charge/discharge control device according to the embodiment.

Description of Embodiments

(Overall Configuration of Power Storage Control System)

Hereinafter, an embodiment will be described in detail with reference to the drawings.

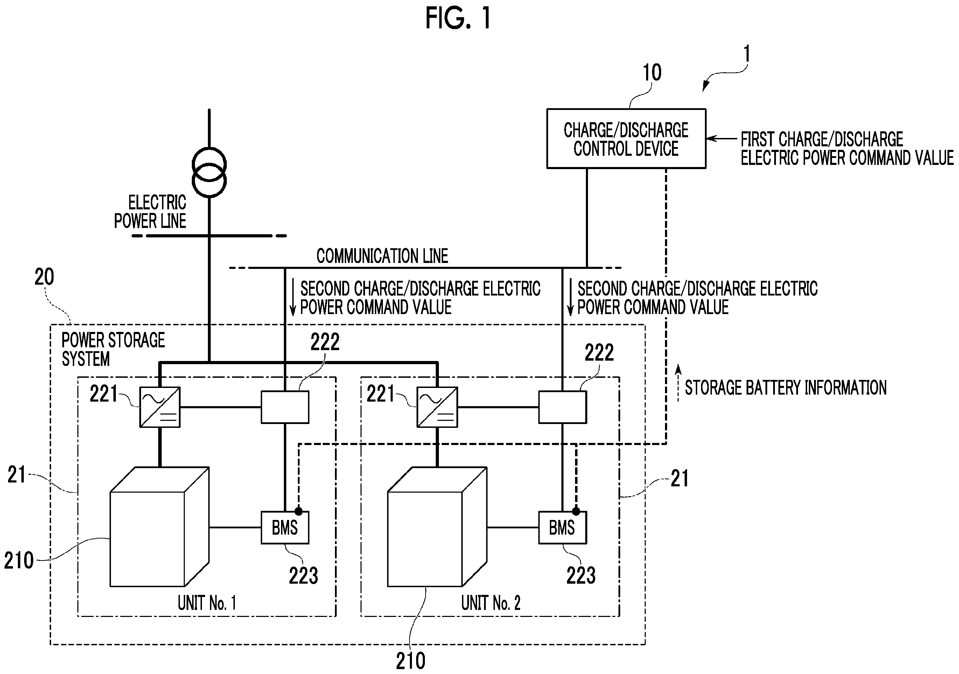

Fig. 1 is a diagram showing an overall configuration of a power storage control system according to an embodiment.
As shown in Fig. 1, a power storage control system 1 includes a charge/discharge control device 10 and a power storage system 20.
The power storage system 20 includes a plurality of storage battery units 21. The power storage system 20 is installed in, for example, a facility such as a factory, an office, or a house, and in a case where the consumed electric power of a load (not shown) in the facility exceeds the contracted electric power with the electric power company, the power storage system 20 supplies electric power charged in the storage battery unit 21 to the load to complement shortage electric power. In addition, in a case where the consumed electric power of the load is smaller than the contracted electric power, the power storage system 20 charges the storage battery unit 21 with surplus electric power.
The charge/discharge control device 10 controls each storage battery unit 21 of the power storage system 20 to discharge or charge electric power corresponding to shortage electric power or surplus electric power in the facility. Further, the charge/discharge control device 10 according to the present embodiment adjusts the distribution of electric power charged/discharged to each storage battery unit 21 so that the state of health of each storage battery unit 21 is not biased. In the following description, the command value of the charge/discharge electric power required for the entire power storage system 20 is also referred to as a "first charge/discharge electric power command value", and the command value of the charge/discharge electric power distributed to each of the storage battery units 21 is also referred to as a "second charge/discharge electric power command value". Details of the functional configuration of the charge/discharge control device 10 will be described later.

(Functional Configuration of Power Storage System)

Each of the storage battery units 21 of the power storage system 20 includes a storage battery 210, a power conditioning system (PCS; power conditioner) 221, a PCS controller 222, and a battery management system (BMS) 223.
The PCS 221 switches charging/discharging of the storage battery 210 in accordance with the control of the PCS controller 222. The PCS 221 includes a circuit or the like that converts alternating current electric power and direct current electric power into each other in a bidirectional manner. The PCS 221 converts the alternating current electric power supplied through the electric power line into direct current electric power and inputs the direct current electric power to the storage battery 210 during charging, and converts the direct current electric power discharged from the storage battery 210 into alternating current electric power and outputs the alternating current electric power to the electric power line during discharging.

The PCS controller 222 receives the second charge/discharge electric power command value from the charge/discharge control device 10 through the communication line, and controls the PCS 221 such that electric power corresponding to the second charge/discharge electric power command value is charged to the storage battery 210 or discharged from the storage battery 210.

The BMS 223 monitors the state of the storage battery 210 and transmits the monitored state to the charge/-discharge control device as the storage battery information. The storage battery information includes, for example, a state of charge (SOC [%]) and a state of health (SOH [%]) of the storage battery 210. In addition, the storage battery information may further include a cell voltage [V], a cell current [A], a cell temperature [°C], and the like of the storage battery 210.

The SOC represents a ratio of a current dischargeable battery capacity to a maximum battery capacity of the storage battery 210 that is chargeable/dischargeable. SOH represents a ratio (capacity retention ratio) of the current maximum battery capacity (maximum battery capacity in a case of deterioration) to the maximum battery capacity (initial maximum battery capacity) in a case where the storage battery 210 is new. For example, in a case where the initial maximum battery capacity is 50 Ah and the current maximum battery capacity is 40 Ah, the SOH of this storage battery is "40 Ah/50 Ah * 100 = 80%".

The current maximum battery capacity required for estimating the SOH can be obtained, for example, by integrating the current in a case where the SOC is charged from the SOC lower limit value (for example, 0%) to the SOC upper limit value (for example, 100%) at a certain current. The SOC lower limit value and the SOC upper limit value are values set by the user as desired. For example, in another embodiment, the SOC lower limit value may be set to 10%, the SOC upper limit value may be set to 90%, and the like. Specifically, the BMS 223 obtains the current maximum battery capacity by measuring the cell voltage and the current of the storage battery 210, charging the storage battery 210 from the cell voltage corresponding to the SOC lower limit value to the cell voltage corresponding to the SOC upper limit value, and integrating the current measured during the charging.

In a case where a cell voltage [V] at an SOC lower limit value is defined as $V_0$, a cell voltage [V] at an SOC upper limit value is defined as $V_1$, a cell open-circuit voltage characteristic with respect to the SOC is defined as f, a cell current [A] is defined as I, a charging start time is defined as $t_0$, a charging end time is defined as $t_1$, a current maximum battery capacity [Ah] is defined as Q, and an initial maximum battery capacity [Ah] is defined as $Q_0$, the SOH [%] is obtained by Equation (1). The cell open-circuit voltage characteristic is, for example, data obtained by performing a known cell characteristic acquisition test. In addition, the initial maximum battery capacity is a value input by the user.

$$V_0 = f(SOC = 0\%)$$
$$V_1 = f(SOC = 100\%)$$
$$Q = \frac{1}{3600}\int_{t_0}^{t_1} I dt \qquad \cdots(1)$$
$$SOH = \frac{Q}{Q_o} \times 100$$

It is noted that the SOH can also be measured at the time of the discharge of the storage battery 210 by using Equation (1). In this case, the discharge is performed from the cell voltage corresponding to the SOC upper limit value to the cell voltage corresponding to the SOC lower limit value, and the current measured during the discharging is integrated to obtain the SOH.

In addition, the method by which the BMS 223 calculates the SOH is not limited to the above. In another embodiment, the BMS 223 may calculate the SOH using other known techniques.

(Functional Configuration of Charge/Discharge Control Device)

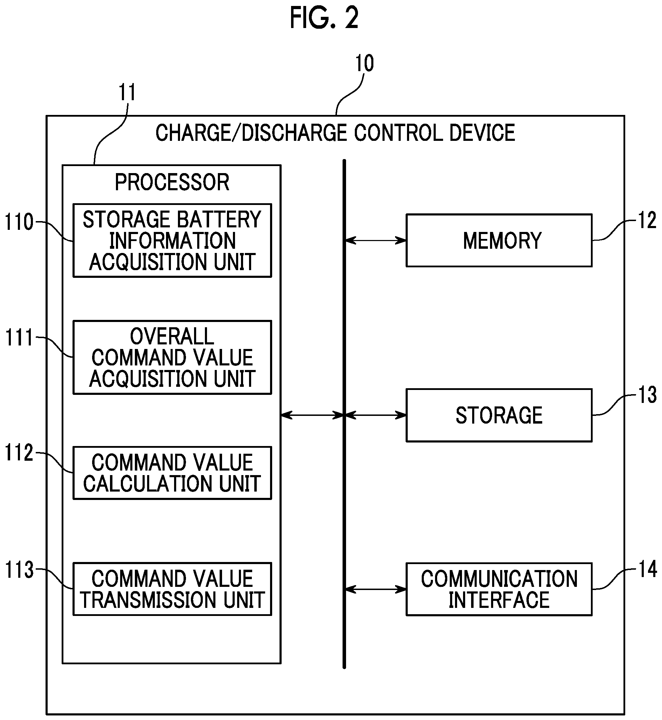

Fig. 2 is a block diagram showing a functional configuration of the charge/discharge control device according to the embodiment.

As shown in Fig. 2, the charge/discharge control device 10 includes a processor 11, a memory 12, a storage 13, and a communication interface 14.

The memory 12 includes a memory region necessary for the operation of the processor 11.

The storage 13 is a so-called auxiliary storage device, and is, for example, a Hard Disk Drive (HDD), a Solid State Drive (SSD), or the like.

The communication interface 14 is an interface for transmitting and receiving various kinds of information to and from an external device (PCS controller 222, BMS 223, or the like).

The processor 11 operates in accordance with a predetermined program to exhibit functions as a storage battery information acquisition unit 110, an overall command value acquisition unit 111, a command value calculation unit 112, and a command value transmission unit 113.

The storage battery information acquisition unit 110 acquires the storage battery information including the state of health (SOH) and the state of charge (SOC) of each of a plurality of the storage batteries 210 from the BMS 223 of each storage battery unit 21.

The overall command value acquisition unit 111 acquires a first charge/discharge electric power command value indicating charge/discharge electric power required for the entire power storage system 20.

The command value calculation unit 112 calculates a second charge/discharge electric power command value, which indicates charge/discharge electric power to be assigned to each of the storage batteries 210, out of the first charge/discharge electric power command value, based on the storage battery information of each storage battery 210. Further, the command value calculation unit 112 according to the present embodiment switches a mode for calculating the second charge/discharge electric power command value based on the state of charge (SOC) of each storage battery 210. The command value calculation unit 112 has two modes of a first mode (SOC balance control mode) for calculating the second charge/discharge electric power command value based on the state of charge (SOC) of each storage battery 210 and a second mode (SOH balance control mode) for calculating the second charge/discharge electric power command value based on the state of health (SOH) of each storage battery 210. Details of the processing of switching between the two modes by the command value calculation unit 112 will be described below.

The command value transmission unit 113 transmits the second charge/discharge electric power command value calculated by the command value calculation unit 112 to the PCS controller 222 of each storage battery unit through the communication line.

(Processing Flow of Charge/Discharge Control Device)

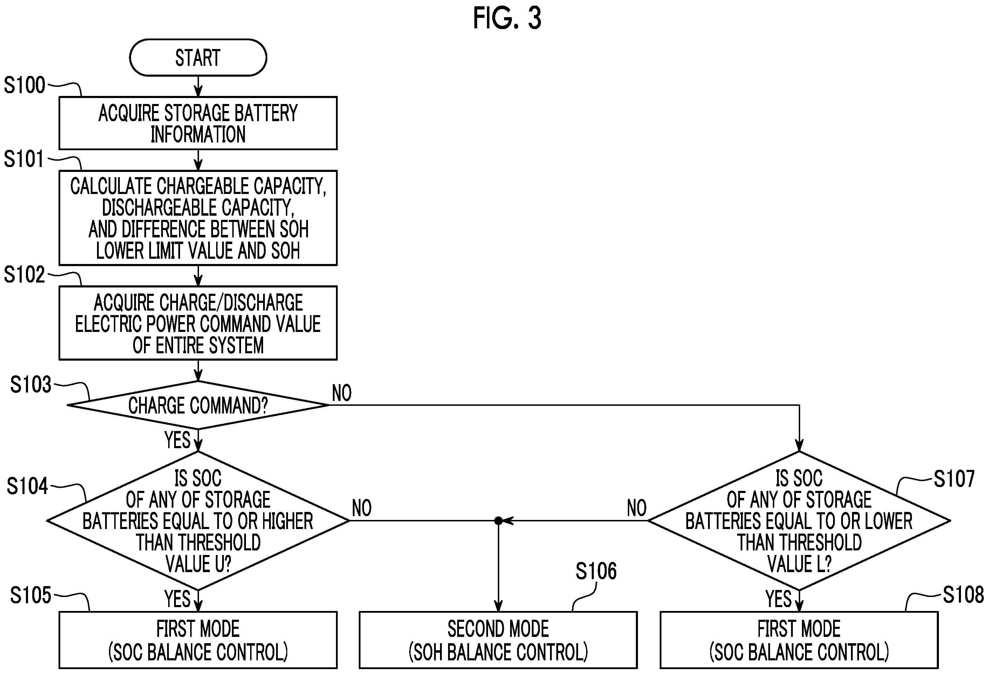

Fig. 3 is a first flowchart showing an example of the processing of the charge/discharge control device according to the embodiment.

Fig. 3 shows an example of processing of determining a mode for calculating a second charge/discharge electric power command value in a case in which the charge/discharge control device 10 controls the charging/discharging of each storage battery.

First, the storage battery information acquisition unit 110 acquires the storage battery information including the SOC and the SOH of the storage battery 210 from the BMS 223 of each storage battery unit 21 (step S100).

Next, the command value calculation unit 112 calculates the chargeable capacity [kWh], the dischargeable capacity [kWh], and a difference between the SOH lower limit value [%] and SOH of each storage battery 210 based on the storage battery information (step S101).

For example, the storage 13 records in advance the initial charge/discharge capacity [kWh] and the SOH lower limit value [%] of each storage battery 210 input in advance by the user. The SOH lower limit value is a reference for determining whether or not the storage battery 210 needs to be replaced, and the storage battery 210 is replaced with a new storage battery in a case where the SOH is equal to or lower than the SOH lower limit value. The command value calculation unit 112 calculates the current charge/discharge maximum capacity [kWh] of the storage battery 210 based on the initial charge/discharge capacity and the SOH recorded in the storage 13. For example, in a case where the initial charge/discharge capacity is 100 kWh and the SOH is 90%, the current charge/discharge maximum capacity of the storage battery 210 is "100 kWh $\times$ 90%/100 = 90 kWh". In addition, the command value calculation unit 112 calculates the chargeable capacity and the dischargeable capacity of the storage battery 210 based on the current charge/discharge maximum capacity [kWh] and the SOC. In a case where the current charge/discharge maximum capacity is 90 kWh and the SOC is 60%, the chargeable capacity is "90 kWh $\times$ (100 - 60%)/100 = 36 kWh", and the dischargeable capacity is "90 kWh $\times$ 60%/100 = 54 kWh". It should be noted that the command value calculation unit 112 calculates a difference from the SOH lower limit value by subtracting the SOH lower limit value read out from the storage 13 from the SOH included in the storage battery information. In a case where the SOH lower limit value is 80% and SOH is 90%, the difference from the SOH lower limit value is "90% - 80% = 10%".

The overall command value acquisition unit 111 acquires a first charge/discharge electric power command value that is a command value of the charge/discharge electric power required for the entire power storage system 20 (step S102). For example, the overall command value acquisition unit 111 acquires the first charge/discharge electric power command value corresponding to the shortage electric power or the surplus electric power in the facility from a monitoring system (not shown) that monitors the consumed electric power of the load in the facility. It should be noted that, in another embodiment, the overall command value acquisition unit 111 may calculate the first charge/discharge electric power command value based on the shortage electric power or the surplus electric power calculated from the contracted electric power of the facility and the consumed electric power in the facility. In addition, while Fig. 3 shows an example in which step S103 is executed after steps S100 and S101, the present disclosure is not limited to this. In another embodiment, step S103 may be executed before steps S100 and S101, or may be executed in parallel with steps S100 and S101.

Next, the command value calculation unit 112 performs processing of switching the mode (the first mode or the second mode) for calculating the second charge/discharge electric power command value for each storage battery 210.

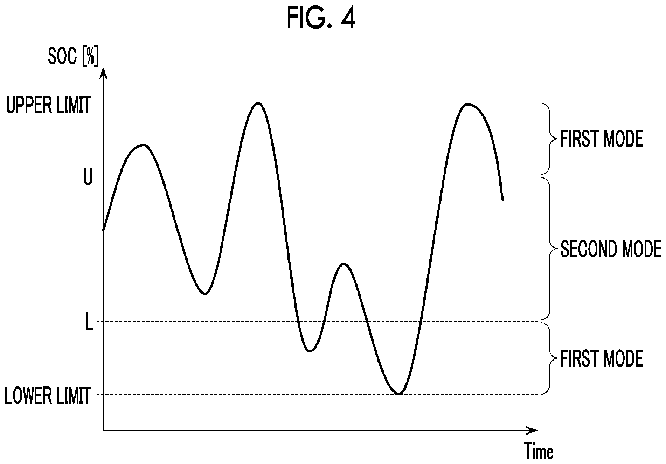

Fig. 4 is a first diagram for describing the functions of the charge/discharge control device according to the embodiment.

Fig. 4 shows an example of a time series of the SOC of a certain storage battery. The first mode is an SOC balance control mode, and is a mode in which, in a case where the SOC of any storage battery 210 is close to the SOC upper limit value (for example, equal to or higher than the first threshold value U [%]) or is close to the SOC lower limit value (for example, equal to or lower than the second threshold value L [%]), the assignment of the charge/discharge electric power for each storage battery is adjusted based on the SOC of each storage battery, giving priority to the chargeable capacity or the dischargeable capacity of the storage battery. The SOC upper limit value, the SOC lower limit value, the first threshold value U, and the second threshold value L of each storage battery 210 are set to any values by the user, respectively, and are stored in the storage 13.

The second mode is an SOH balance control mode, and is a mode in which, in a case where the SOC of all the storage batteries 210 is separated from both the upper limit value and the lower limit value, the assignment of charge/discharge electric power for each storage battery is adjusted based on the SOH of each storage battery, giving priority the extension of the lifetime of the storage battery.

Specifically, the command value calculation unit 112 first determines whether the first charge/discharge electric power command value is a charge command or a discharge command (step S103).

In a case where the first charge/discharge electric power command value is the charge command (step S103; YES), the command value calculation unit 112 determines whether or not the SOC of at least one of the plurality of storage batteries 210 is equal to or higher than the first threshold value U (step S104).

In a case where the SOC of the at least one storage battery 210 is equal to or higher than the first threshold value U (step S104; YES), the command value calculation unit 112 switches to the first mode (step S105).

On the other hand, in a case where the SOC of all the storage batteries 210 is lower than the first threshold value U (step S104; NO), the command value calculation unit 112 switches to the second mode (step S106).

In addition, in a case where the first charge/discharge electric power command value is the discharge command (step S103; NO), the command value calculation unit 112 determines whether or not the SOC of at least one of the plurality of storage batteries 210 is equal to or lower than the second threshold value L (step S107).

In a case where the SOC of the at least one storage battery 210 is equal to or higher than the second threshold value L (step S107; YES), the command value calculation unit 112 switches to the first mode (step S108).

On the other hand, in a case where the SOC of all the storage batteries 210 exceeds the second threshold value L (step S107; NO), the command value calculation unit 112 switches to the second mode (step S106).

The charge/discharge control device 10 executes a series of pieces of processing in Fig. 3 for each predetermined time to switch to the first mode or the second mode.

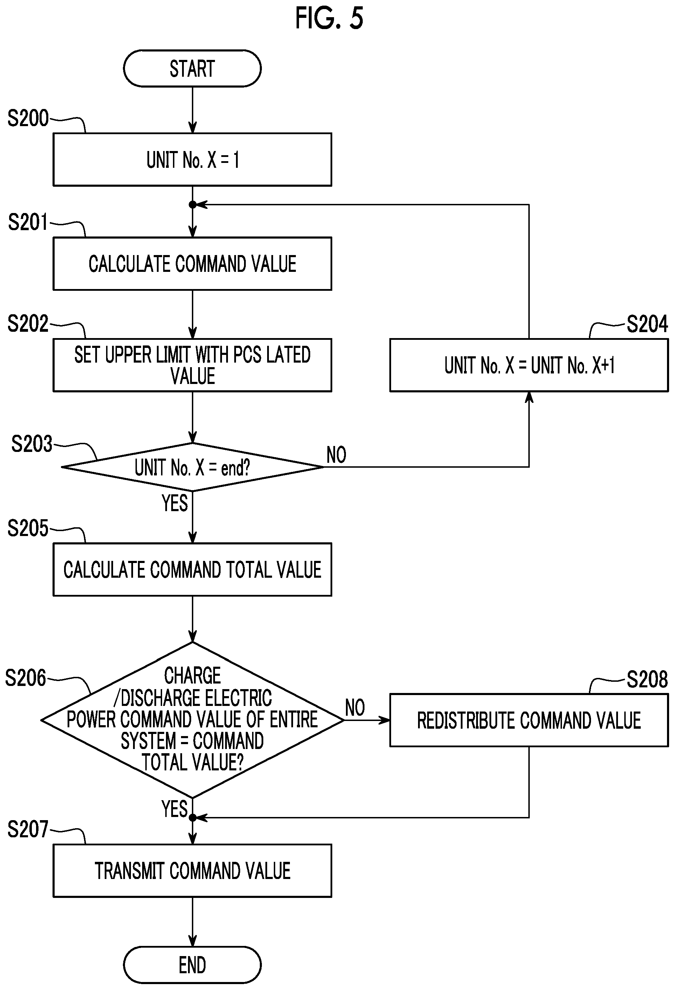

Fig. 5 is a second flowchart showing an example of the processing of the charge/discharge control device according to the embodiment.

Fig. 5 shows an example of processing of distributing the charge/discharge electric power requested by the first charge/discharge electric power command value to each storage battery by the command value calculation unit 112 in the first mode (SOC balance control mode).

First, the command value calculation unit 112 sets the unit No. X of the storage battery to be used for calculation of the command value to the identification number (for example, "1") of the first storage battery 210 among the plurality of storage batteries 210 (step S200).

Further, the command value calculation unit 112 calculates the second charge/discharge electric power command value of the storage battery 210 of the unit No. X (step S201). For example, in a case where the first charge/discharge electric power command value is the discharge command, the command value calculation unit 112 calculates the discharge electric power command value of the unit No. X by Equation (2) based on the dischargeable capacity of the unit No. X and the discharge electric power command value (first charge/discharge electric power command value) required for the entire power storage system 20.

$$\text{Discharge electric power command value of unit } No.\ X = \text{Discharge electric power command value of entire system} \times \frac{\text{Dischargeable capacity of unit } No.\ X}{\sum \text{Dischargeable capacity of each unit}}$$

$$\cdots (2)$$

In addition, in a case where the first charge/discharge electric power command value is the charge command, the command value calculation unit 112 calculates the charge electric power command value of the unit No. X by Equation (3) based on the chargeable capacity of the unit No. X and the charge electric power command value (first charge/discharge electric power command value) of the entire system.

$$\text{Charge electric power command value of unit } No. X = \text{Charge electric power command value of entire system} \times \frac{\text{Chargeable capacity of unit } No. X}{\sum \text{Chargeable capacity of each unit}}$$

$$\cdots (3)$$

In addition, the command value calculation unit 112 limits the second charge/discharge electric power command value for the unit No. X not to exceed the charge/discharge capacity of the storage battery 210, that is, not to exceed the PCS rated value which is the upper limit value of the electric power preset in the PCS 221 (step S202). That is, in a case where the second charge/discharge electric power command value is a value higher than the PCS rated value, the command value calculation unit 112 changes the second charge/discharge electric power command value to the same value as the PCS rated value. The PCS rated value of each storage battery unit 21 may be recorded in advance in the storage 13 or may be acquired from the PCS controller 222.

Next, the command value calculation unit 112 determines whether or not the unit No. X is the identification number of the last storage battery 210, that is, whether or not the second charge/discharge electric power command values for all the storage batteries 210 have been calculated (step S203). In a case where the unit No. X is not the identification number of the last storage battery 210 (step S203; NO), the command value calculation unit 112 adds 1 to the unit No. X (step S204) and returns to step S201 in order to calculate the second charge/discharge electric power command value of the next unit No. X+1.

In addition, in a case where the unit No. X is the identification number of the last storage battery 210 (step S203; YES), the total value (command total value) of the second charge/discharge electric power command values of each of the storage batteries 210 is calculated (step S205).

Next, the command value calculation unit 112 determines whether or not the command total value matches the first charge/discharge electric power command value requested for the power storage system 20 (step S206).

In a case where the command total value matches the first charge/discharge electric power command value requested for the power storage system 20 (step S206; YES), the command value calculation unit 112 transmits the second charge/discharge electric power command value calculated in steps S201 and S202 to the PCS controller 222 of each storage battery unit 21 (step S208).

On the other hand, in a case where the command total value does not match the first charge/discharge electric power command value requested for the power storage system 20 (step S206; NO), the command value calculation unit 112 redistributes the second charge/discharge electric power command values for the respective storage batteries 210 (step S208).

For example, in a case where the command value calculated in step S201 for a certain storage battery 210 is lowered to the PCS rated value in step S202, the command total value may be lower than the first charge/discharge electric power command value. In a case where the command total value is lower than the charge electric power command value required for the entire power storage system 20, the command value calculation unit 112 extracts the storage battery 210 of which the second charge/discharge electric power command value is lower than the PCS rated value, and distributes the shortage of charge electric power from the storage battery 210 having a larger chargeable capacity among the extracted storage batteries 210 in order. In addition, in a case where the command total value is lower than the discharge electric power command value required for the entire power storage system 20, the command value calculation unit 112 extracts the storage battery 210 of which the second charge/discharge electric power command value is lower than the PCS rated value, and distributes the shortage of the discharge electric power in order from the storage battery 210 having a larger dischargeable capacity among the extracted storage batteries 210.

In a case where the redistribution of the shortage is completed, the command value calculation unit 112 transmits the second charge/discharge electric power command value redistributed in step S208 to the PCS controller 222 of each storage battery unit 21 (step S207).

As described above, in the first mode, the charge/discharge control device 10 distributes the charge/discharge electric power required for the entire system to each storage battery 210 such that the larger the dischargeable capacity or the chargeable capacity, the larger the assigned discharge electric power or charge electric power. With this, the charge/discharge control device 10 can adjust the SOC of each storage battery 210 to be substantially equal.

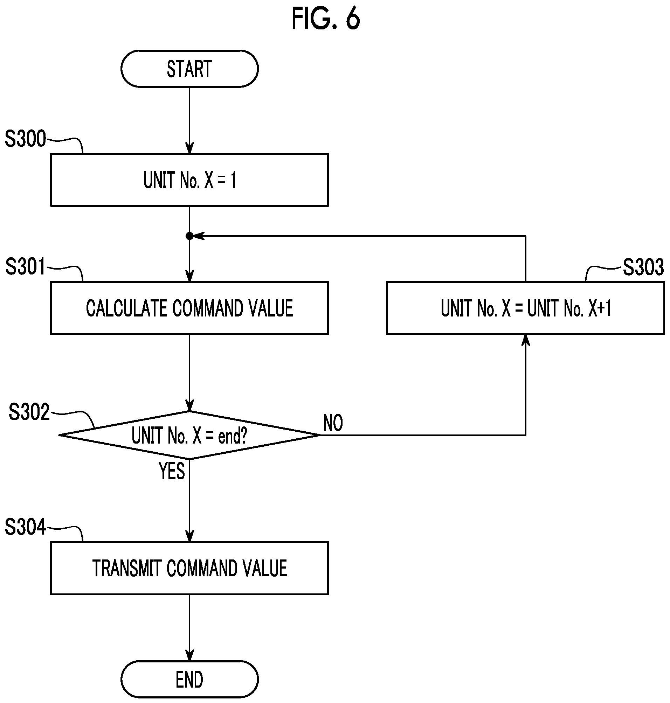

Fig. 6 is a third flowchart showing an example of the processing of the charge/discharge control device according to the embodiment.

Fig. 6 shows an example of processing of distributing the charge/discharge electric power requested by the first charge/discharge electric power command values to the respective storage batteries by the command value calculation unit 112 in the second mode (SOH balance control mode).

First, the command value calculation unit 112 sets the unit No. X of the storage battery to be used for calculation of the command value as the identification number (for example, "1") of the first storage battery 210 among the plurality of storage batteries 210 (step S300).

In addition, the command value calculation unit 112 calculates the second charge/discharge electric power command value of the storage battery 210 of the unit No. X (step S301). For example, in a case where the first charge/discharge electric power command value is the discharge command, the command value calculation unit 112 calculates the discharge electric power command value of the unit No. X by Equation (4) based on the dischargeable capacity of the unit No. X and the discharge electric power command value (first charge/discharge electric power command value) required for the entire power storage system 20.

$$\text{Discharge electric power command value of unit } No.\ X = \text{Discharge electric power command value of entire system} \times \frac{SOH - SOH \text{ lower limit value of unit } No.\ X}{\sum SOH - SOH \text{ lower limit value of each unit}} \quad \cdots(4)$$

In addition, in a case where the first charge/discharge electric power command value is a charge command, the command value calculation unit 112 calculates the charge electric power command value of the unit No. X by Equation (5) based on the chargeable capacity of the unit No. X and the charge electric power command value (first charge/discharge electric power command value) of the entire system.

$$\text{Charge electric power command value of unit } No.\ X = \text{Charge electric power command value of entire system} \times \frac{SOH - SOH \text{ lower limit value of unit } No.\ X}{\sum SOH - SOH \text{ lower limit value of each unit}} \quad \cdots(5)$$

Next, the command value calculation unit 112 determines whether or not the unit No. X is the identification number of the last storage battery 210, that is, whether or not the second charge/discharge electric power command values for all the storage batteries 210 have been calculated (step S302). In a case where the unit No. X is not the identification number of the last storage battery 210 (step S302; NO), the command value calculation unit 112 adds 1 to the unit No. X (step S303) and returns to step S301 in order to calculate the second charge/discharge electric power command value of the next unit No. X+1.

Further, in a case where the unit No. X is the identification number of the last storage battery 210 (step S302; YES), the second charge/discharge electric power command value calculated in step S301 is transmitted to the PCS controller 222 of each storage battery unit 21 (step S304).

The more electric power the storage battery 210 charges/discharges, the faster the decrease in SOH tends to be. Therefore, in the second mode, the charge/discharge control device 10 distributes the charge/discharge electric power required for the entire system to each storage battery 210 such that the larger the difference from the SOH lower limit value (the margin to the SOH lower limit value), the larger the charge/discharge electric power assigned. With this, the charge/discharge control device 10 can adjust the distribution of the charge/discharge electric power such that the decreasing rate in the SOH is reduced for the storage battery 210 having a large difference from the SOH lower limit value and the variation in the SOH of the storage battery 210 is reduced.

The charge/discharge control device 10 executes a series of pieces of processing of Fig. 5 or Fig. 6 for each predetermined time to transmit the second charge/discharge electric power command value to each storage battery unit 21 and to control the charging/discharging of the storage battery 210.

(Operation and Effect of Charge/Discharge Control Device)

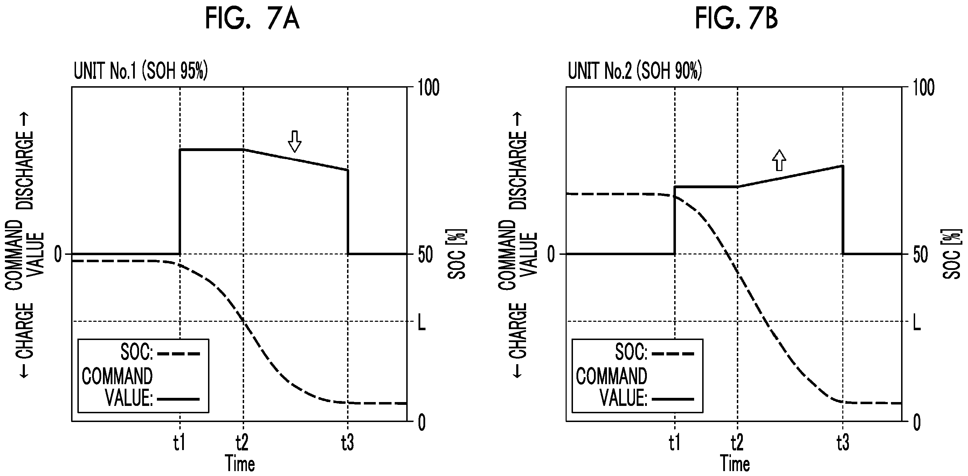

Figs. 7A and 7B are second diagrams for describing the functions of the charge/discharge control device according to the embodiment. Fig. 7A shows an example of the temporal transition of the second charge/discharge electric power command value and the SOC which are output to the storage battery 210 of the unit No. 1 and Fig. 7B shows an example of the temporal transition of the second charge/discharge electric power command value and the SOC which are output to the storage battery 210 of the unit No. 2, for the power storage system 20 having two storage batteries 210 of the unit No. 1 and the unit No. 2. In Figs. 7A and 7B, a broken line represents the transition of the SOC, and a solid line represents the transition of the second charge/discharge electric power command value. In addition, in the period shown in Figs. 7A and 7B, it is assumed that the SOH of the storage battery 210 of the unit No. 1 is 95%, the SOH of the storage battery 210 of the unit No. 2 is 90%, and the SOH lower limit value of each storage battery 210 is 80%.

At time t1, the overall command value acquisition unit 111 of the charge/discharge control device 10 acquires the discharge command value (first charge/discharge electric power command value) for the entire power storage system 20. In addition, since the SOC of each of the two storage batteries 210 exceeds the second threshold value L at time t1 (step S107 in Fig. 3; NO), the command value calculation unit 112 switches to the second mode (SOH balance control mode) (step S106 in Fig. 3) and calculates the command value of each storage battery 210.

In the example in Figs. 7A and 7B, the difference from the SOH lower limit value of the unit No. 1 is 95% - 80% = 15%, and the difference from the SOH lower limit value of the unit No. 2 is 90% - 80% = 10%. Here, in a case where the discharge command value for the entire power storage system 20 is "30 kW", the discharge command value of the unit No. 1 is 30 kW × 15%/(15% + 10%) = 18 kW, and the discharge command value of the unit No. 2 is 30 kW × 10%/(15% + 10%) = 12 kW.

Further, it is assumed that the SOC of the unit No. 1 is the second threshold value L or lower at time t2 (step S107 in Fig. 3; YES). In this case, the command value calculation unit 112 switches to the first mode (SOC balance control mode) after the time t2 (step S108 in Fig. 3) and calculates the command value of each storage battery 210.

It is assumed that the dischargeable capacity of the unit No. 1 is 80 kWh and the dischargeable capacity of the unit No. 2 is 120 kWh at time t2. Here, in a case where the discharge command value for the entire power storage system 20 is "30 kW", the discharge command value of the unit No. 1 is 30 kW × 80 kWh/(80 kWh + 120 kWh) = 12 kW, and the discharge command value of the unit No. 2 is 30 kW × 120 kWh/(80 kWh + 120 kWh) = 18 kW. As described above, by adjusting the value of the discharge command value in accordance with the SOC in the period after the time t2, the SOC of the units No. 1 and No. 2 is the same near the time t3, and the variation in the SOC of each storage battery 210 is resolved.

As described above, the charge/discharge control device 10 according to the present embodiment calculates the second charge/discharge electric power command value of the first charge/discharge electric power command value required for the entire power storage system 20 that is assigned to each storage battery, based on the state of health (SOH) of the storage battery 210. With this, the charge/discharge control device 10 can perform charge/discharge control while balancing the SOHs of the respective storage batteries 210.

Specifically, the charge/discharge control device 10 adjusts the distribution of the second charge/discharge electric power command value in accordance with a value obtained by subtracting the SOH lower limit value from the SOH of the storage battery 210. For example, as in Figs. 7A and 7B, in a case where the difference of the unit No. 1 from the SOH lower limit value (the margin to the SOH lower limit value) is larger than that of the unit No. 2, the discharge electric power to be distributed to the unit No. 1 is relatively large. As described above, the charge/discharge control device 10 can make the decreasing rate of the SOH of the unit No. 2 slower than that of the unit No. 1, and thus can reduce the variation in the SOH of the unit No. 1 and the unit No. 2. That is, it is possible to suppress the shortening of the lifetime (the period until the SOH lower limit value is reached) of the unit No. 2 as compared with the unit No. 1.

Further, the charge/discharge control device 10 switches to a first mode (SOC balance control mode) in which the charge electric power (second charge/discharge electric power command value) of each storage battery 210 is calculated based on the SOC in a case where the first charge/discharge electric power command value is the charge command and the SOC of at least one storage battery 210 is equal to or higher than the first threshold value U. Accordingly, in a case where there is a storage battery 210 of which the SOC is close to the SOC upper limit value, the charge/discharge control device 10 can adjust the SOC of each storage battery 210 to be substantially equal by changing the magnitude of the charge electric power in accordance with the SOC of each storage battery 210.

Further, the charge/discharge control device 10 switches to a first mode (SOC balance control mode) in which the discharge electric power (second charge/discharge electric power command value) of each storage battery 210 is calculated based on the SOC in a case where the first charge/discharge electric power command value is the discharge command and the SOC of at least one storage battery 210 is equal to or lower than the second threshold value L. Accordingly, in a case where there is the storage battery 210 of which the SOC is close to the SOC lower limit, the charge/discharge control device 10 can adjust the SOC of each storage battery 210 to be substantially equal by changing the magnitude of the discharge electric power in accordance with the SOC of each storage battery 210.

Further, the charge/discharge control device 10 switches to a second mode (SOH balance control mode) in which the second charge/discharge electric power command value of each storage battery 210 is calculated based on the SOH in a case where the first charge/discharge electric power command value is a charge command and the SOC of all the storage batteries 210 is lower than the first threshold value U, or in a case where the first charge/discharge electric power command value is a discharge command and the SOC of all the storage batteries 210 exceeds the second threshold value L. In a case where the charge/discharge control device 10 switches between the first mode and the second mode in this way to adjust the charge/discharge electric power of the storage battery 210, it is possible to achieve both the effect of suppressing the shortage of the chargeable capacity or the dischargeable capacity of each storage battery 210 and the effect of reducing the variation in the SOH of each storage battery 210.

As described above, some embodiments according to the present disclosure have been described, but all of these embodiments are presented as examples and are not intended to limit the scope of the invention. These embodiments can be implemented in various other forms, and various omissions, replacements, and changes can be made without departing from the gist of the invention. These embodiments and modifications thereof are included in the scope of the invention described in the claims and the equivalent scope thereof, as well as in the scope and gist of the invention.

<Additional Notes>

For example, the above-described embodiments are understood as follows.

(1) According to a first aspect, a charge/discharge control device 10 of a power storage system 20 including a plurality of storage batteries 210 includes a storage battery information acquisition unit 110 that acquires storage battery information including a state of health (SOH) of each of the plurality of storage batteries 210, an overall command value acquisition unit 111 that acquires a first charge/discharge electric power command value indicating charge/-discharge electric power required for an entire power storage system 20, and a command value calculation unit 112 that calculates a second charge/discharge electric power command value, which indicates charge/discharge electric power to be assigned to each of the storage batteries 210, out of the first charge/discharge electric power command value, based on the state of health.

As described above, the charge/discharge control device 10 can perform the charge/discharge control while balancing the state of health of each storage battery 210.

(2) According to a second aspect, in the charge/discharge control device 10 according to the first aspect, the command value calculation unit 112 calculates the second charge/discharge electric power command value such that charge/discharge electric power corresponding to a value obtained by subtracting a predetermined lower limit value of the state of health from the state of health is distributed to the storage batteries 210.

As a result, the charge/discharge control device 10 can set the decreasing rate of the state of health of the storage battery 210 having a large difference from the lower limit value of state of health to be slower than the decreasing rate of the state of health of the storage battery 210 having a small difference from the lower limit value of state of health, and thus can reduce the variation in the state of health of each storage battery 210.

(3) According to a third aspect, in the charge/discharge control device 10 according to the first or second aspect, the command value calculation unit 112 calculates the second charge/discharge electric power command value based on a state of charge (SOC) included in the storage battery information instead of the state of health in a case where the first charge/discharge electric power command value is a value indicating a charge command and the state of charge of at least one of the storage batteries 210 is equal to or higher than a first threshold value U.

As described above, in a case where there is the storage battery 210 of which the state of charge is equal to or higher than the first threshold value U (close to the upper limit), the charge/discharge control device 10 can adjust the state of charge of each storage battery 210 to be substantially equal by changing the magnitude of the charge electric power in accordance with the state of charge of each storage battery 210.

(4) According to a fourth aspect, in the charge/discharge control device 10 according to any one of the first to third aspects, the command value calculation unit 112 calculates the second charge/discharge electric power command value based on a state of charge included in the storage battery information instead of the state of health in a case where the first charge/discharge electric power command value is a value indicating a discharge command and the state of charge of at least one of the storage batteries 210 is equal to or lower than a second threshold value L.

As described above, in a case where there is the storage battery 210 of which the state of charge is the second threshold value L or lower (close to the lower limit), the charge/discharge control device 10 can adjust the state of charge of each storage battery 210 to be substantially equal by changing the magnitude of the charge electric power in accordance with the state of charge of each storage battery 210.

(5) According to a fifth aspect, a charge/discharge control method of a power storage system 20 including a plurality of storage batteries 210 includes a step of acquiring storage battery information including a state of health of each of the plurality of storage batteries 210, a step of acquiring a first charge/discharge electric power command value indicating charge/discharge electric power required for an entire power storage system 20, and a step of calculating a second charge/discharge electric power command value, which indicates charge/discharge electric power to be assigned to each of the storage batteries 210, out of the first charge/discharge electric power command value, based on the state of health.

(6) According to a sixth aspect, a program causes a charge/discharge control device 10 of a power storage system 20 including a plurality of storage batteries 210 to execute a step of acquiring storage battery information including a state of health of each of the plurality of storage batteries 210, a step of acquiring a first charge/discharge electric power command value indicating charge/discharge electric power required for an entire power storage system 20, and a step of calculating a second charge/discharge electric power command value, which indicates charge/discharge electric power to be assigned to each of the storage batteries 210, out of the first charge/discharge electric power command value, based on the state of health.

Industrial Applicability

According to the present disclosure, it is possible to provide a charge/discharge control device, a charge/-discharge control method, and a program capable of reducing variations in the state of health of a plurality of storage batteries included in a power storage system.

Reference Signs List

1: power storage control system
10: charge/discharge control device
11: processor
110: storage battery information acquisition unit
111: overall command value acquisition unit
112: command value calculation unit
113: command value transmission unit
12: memory
13: storage
14: communication interface
20: power storage system
21: storage battery unit
210: storage battery
221: PCS
222: PCS controller
223: BMS

**Claims**

1. A charge/discharge control device of a power storage system including a plurality of storage batteries, the charge/discharge control device comprising:

   a storage battery information acquisition unit that acquires storage battery information including a state of health of each of the plurality of storage batteries;
   an overall command value acquisition unit that acquires a first charge/discharge electric power command value indicating charge/discharge electric power required for an entire power storage system; and
   a command value calculation unit that calculates a second charge/discharge electric power command value, which indicates charge/discharge electric power to be assigned to each of the storage batteries, out of the first charge/discharge electric power command value, based on the state of health.

2. The charge/discharge control device according to Claim 1,
   wherein the command value calculation unit calculates the second charge/discharge electric power command value such that charge/discharge electric power corresponding to a value obtained by subtracting a predetermined lower limit value of the state of health from the state of health is distributed to the storage batteries.

3. The charge/discharge control device according to Claim 1 or 2,
   wherein the command value calculation unit calculates the second charge/discharge electric power command value based on a state of charge included in the storage battery information instead of the state of health in a case where the first charge/discharge electric power command value is a value indicating a charge command and the state of charge of at least one of the storage batteries is equal to or higher than a first threshold value.

4. The charge/discharge control device according to Claim 1 or 2,
   wherein the command value calculation unit calculates the second charge/discharge electric power command value based on a state of charge included in the storage battery information instead of the state of health in a case where the first charge/discharge electric power command value is a value indicating a discharge command and the state of charge of at least one of the storage batteries is equal to or lower than a second threshold value.

5. A charge/discharge control method of a power storage system including a plurality of storage batteries, the charge/discharge control method comprising:

   a step of acquiring storage battery information including a state of health of each of the plurality of storage batteries;
   a step of acquiring a first charge/discharge electric power command value indicating charge/discharge electric power required for an entire power storage system; and

a step of calculating a second charge/discharge electric power command value, which indicates charge/-discharge electric power to be assigned to each of the storage batteries, out of the first charge/discharge electric power command value, based on the state of health.

6. A program causing a charge/discharge control device of a power storage system including a plurality of storage batteries to execute:

a step of acquiring storage battery information including a state of health of each of the plurality of storage batteries;

a step of acquiring a first charge/discharge electric power command value indicating charge/discharge electric power required for an entire power storage system; and

a step of calculating a second charge/discharge electric power command value, which indicates charge/-discharge electric power to be assigned to each of the storage batteries, out of the first charge/discharge electric power command value, based on the state of health.

# FIG. 1

CHARGE/DISCHARGE CONTROL DEVICE — 10

1

← FIRST CHARGE/DISCHARGE ELECTRIC POWER COMMAND VALUE

ELECTRIC POWER LINE

COMMUNICATION LINE

20

↓ SECOND CHARGE/DISCHARGE ELECTRIC POWER COMMAND VALUE

↓ SECOND CHARGE/DISCHARGE ELECTRIC POWER COMMAND VALUE

POWER STORAGE SYSTEM

222

222

↑ STORAGE BATTERY INFORMATION

221

221

21

21

210

BMS

BMS

223

223

UNIT No. 1

UNIT No. 2

210

EP 4 510 421 A1

# FIG. 2

CHARGE/DISCHARGE CONTROL DEVICE

PROCESSOR

STORAGE BATTERY
INFORMATION
ACQUISITION UNIT

OVERALL
COMMAND VALUE
ACQUISITION UNIT

COMMAND VALUE
CALCULATION UNIT

COMMAND VALUE
TRANSMISSION UNIT

MEMORY

STORAGE

COMMUNICATION
INTERFACE

## FIG. 3

START

S100 — ACQUIRE STORAGE BATTERY INFORMATION

S101 — CALCULATE CHARGEABLE CAPACITY, DISCHARGEABLE CAPACITY, AND DIFFERENCE BETWEEN SOH LOWER LIMIT VALUE AND SOH

S102 — ACQUIRE CHARGE/DISCHARGE ELECTRIC POWER COMMAND VALUE OF ENTIRE SYSTEM

S103 — CHARGE COMMAND? — NO

YES

S104 — IS SOC OF ANY OF STORAGE BATTERIES EQUAL TO OR HIGHER THAN THRESHOLD VALUE U? — NO

S107 — IS SOC OF ANY OF STORAGE BATTERIES EQUAL TO OR LOWER THAN THRESHOLD VALUE L? — NO

YES

S105 — FIRST MODE (SOC BALANCE CONTROL)

S106 — SECOND MODE (SOH BALANCE CONTROL)

YES

S108 — FIRST MODE (SOC BALANCE CONTROL)

EP 4 510 421 A1

# FIG. 4

# FIG. 5

```
                        ┌──────────┐
                        │  START   │
                        └────┬─────┘
                             │
  S200 ──┐    ┌──────────────▼──────────────┐
         └─── │        UNIT No. X = 1        │
              └──────────────┬──────────────┘
                             │
                             ●◄────────────────────────────┐
  S201 ──┐    ┌──────────────▼──────────────┐              │
         └─── │    CALCULATE COMMAND VALUE   │              │
              └──────────────┬──────────────┘              │
                             │                             │
  S202 ──┐    ┌──────────────▼──────────────┐   ┌─── S204  │
         └─── │ SET UPPER LIMIT WITH PCS LATED│  ┌──────────▼──────────────┐
              │           VALUE              │   │ UNIT No. X = UNIT No. X+1│
              └──────────────┬──────────────┘   └──────────▲──────────────┘
                             │                             │
  S203 ──┐         ◄─────────▼─────────►     NO            │
         └───      UNIT No. X = end?   ──────────────────►─┘
                   ◄───────────────────►
                             │ YES
  S205 ──┐    ┌──────────────▼──────────────┐
         └─── │ CALCULATE COMMAND TOTAL VALUE│
              └──────────────┬──────────────┘
                             │
  S206 ──┐        ◄──────────▼──────────►            ┌─── S208
         └───         CHARGE                 NO   ┌──────────────────────────┐
                   /DISCHARGE ELECTRIC    ──────► │ REDISTRIBUTE COMMAND VALUE│
                POWER COMMAND VALUE OF ENTIRE     └──────────────┬───────────┘
                 SYSTEM = COMMAND                                │
                   TOTAL VALUE?                                  │
                   ◄───────────────────►                        │
                             │ YES                               │
                             ●◄─────────────────────────────────┘
  S207 ──┐    ┌──────────────▼──────────────┐
         └─── │    TRANSMIT COMMAND VALUE    │
              └──────────────┬──────────────┘
                             │
                        ┌────▼─────┐
                        │   END    │
                        └──────────┘
```

# FIG. 6

START

S300 — UNIT No. X = 1

S301 — CALCULATE COMMAND VALUE

S302 — UNIT No. X = end?    NO

S303 — UNIT No. X = UNIT No. X+1

YES

S304 — TRANSMIT COMMAND VALUE

END

FIG. 7A

FIG. 7B

UNIT No.1 (SOH 95%)

UNIT No.2 (SOH 90%)

## INTERNATIONAL SEARCH REPORT

International application No.

**PCT/JP2023/005665**

### A. CLASSIFICATION OF SUBJECT MATTER

*H02J 7/02*(2016.01)i; *H01M 10/44*(2006.01)i; *H01M 10/48*(2006.01)i; *H02J 3/32*(2006.01)i; *H02J 3/38*(2006.01)i; *H02J 7/00*(2006.01)i; *H02J 7/34*(2006.01)i; *H02J 13/00*(2006.01)i

FI: H02J7/02 J; H02J13/00 311R; H02J7/00 302C; H02J3/38 110; H02J3/32; H02J7/34 D; H01M10/44 P; H01M10/48 P

According to International Patent Classification (IPC) or to both national classification and IPC

### B. FIELDS SEARCHED

Minimum documentation searched (classification system followed by classification symbols)

H02J7/02; H01M10/44; H01M10/48; H02J3/32; H02J3/38; H02J7/00; H02J7/34; H02J13/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2017-28883 A (KYOCERA CORP) 02 February 2017 (2017-02-02) paragraph [0055] | 1, 5-6 |
| A | | 2-4 |
| A | WO 2016/030967 A1 (HITACHI LTD) 03 March 2016 (2016-03-03) entire text, all drawings | 1-6 |
| A | JP 2008-118790 A (HITACHI LTD) 22 May 2008 (2008-05-22) entire text, all drawings | 1-6 |
| A | JP 2009-44862 A (TOYOTA MOTOR CORP) 26 February 2009 (2009-02-26) entire text, all drawings | 1-6 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 April 2023** | **09 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

International application No.

**PCT/JP2023/005665**

| Patent document cited in search report | | | Publication date (day/month/year) | Patent family member(s) | Publication date (day/month/year) |
|---|---|---|---|---|---|
| JP | 2017-28883 | A | 02 February 2017 | (Family: none) | |
| WO | 2016/030967 | A1 | 03 March 2016 | (Family: none) | |
| JP | 2008-118790 | A | 22 May 2008 | (Family: none) | |
| JP | 2009-44862 | A | 26 February 2009 | WO 2009/019992 A1 entire text, all drawings | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022082868 A

- JP 2021093804 A